(19) Europäisches Patentamt / European Patent Office / Office européen des brevets

(11) **EP 4 730 275 A1**

(12) **EUROPEAN PATENT APPLICATION**

(43) Date of publication:
22.04.2026 Bulletin 2026/17

(21) Application number: 25203478.0

(22) Date of filing: 19.09.2025

(51) International Patent Classification (IPC):
**G06V 10/82** (2022.01)    **G06V 20/10** (2022.01)
**G06V 20/13** (2022.01)

(52) Cooperative Patent Classification (CPC):
**G06V 10/82; G06N 3/006; G06N 3/044;
G06N 3/0442; G06N 3/045; G06N 3/0464;
G06N 3/08; G06N 3/084; G06N 3/092; G06N 3/094;
G06N 3/096; G06N 7/01; G06V 20/13;
G06V 20/188;** A01B 76/00

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: 17.10.2024 IN 202421079088

(71) Applicant: **Tata Consultancy Services Limited
Maharashtra (IN)**

(72) Inventors:
• **MOHITE, Jayantrao**
**400601 Thane (West), Maharashtra (IN)**
• **SINGH, Dineshkumar Jang Bahadur**
**400601 Thane (West), Maharashtra (IN)**
• **SAWANT, Suryakant Ashok**
**411057 Pune, Maharashtra (IN)**
• **PAPPULA, Srinivasu**
**500034 Hyderabad, Telangana (IN)**

(74) Representative: **Goddar, Heinz J.
Boehmert & Boehmert
Anwaltspartnerschaft mbB
Pettenkoferstrasse 22
80336 München (DE)**

(54) **METHOD AND SYSTEM TO GENERATE SPATIO-TEMPORAL INTERCROP LAYOUTS USING 3D-CNN-LSTM BASED LARGE VISION MODEL**

(57) This disclosure relates generally to method and system to generate spatio-temporal intercrop layouts using 3D-CNN-LSTM based large vision model. The method is a pretrained spatio-temporal crop interaction model based on a 3D-CNN-LSTM to recommend optimal intercrop combinations. The method initially receives a user request as input which is preprocessed by removing noise and performing normalization. Further, a pretrained 3D-CNN-LSTM model is utilized to generate an optimal spatio-temporal intercrop layout for each intercropping scenario. The method also provides providing dynamic visual insight for the spatio-temporal intercrop layout comprising crop growth and corresponding intercrop interaction. Finally, an user feedback is obtained from at least one of the user or non-invasively in response to the user request for iterative improvements and fine-tuning the 3D-CNN-LSTM model using reinforcement learning.

FIG. 3

300

receive a user request comprising a geotagged boundary of agriculture field and one or more user preferences of expected potential yield, GHG emissions, one or more sustainability score and combination thereof — 302

preprocess the user request by removing noise and performing normalization — 304

utilize a pretrained 3D-CNN-LSTM model to generate an optimal spatio-temporal intercrop layout for each intercrop scenario for the preprocessed user request — 306

dynamically providing a visual insight for the spatio-temporal intercrop layout comprising crop growth and corresponding intercrop interaction — 308

obtain a user feedback from at least one of the user or non-invasively in response to the user request for iterative improvements and fine-tuning the 3D-CNN-LSTM model using reinforcement learning — 310

EP 4 730 275 A1

**Description**

CROSS-REFERENCE TO RELATED APPLICATIONS AND PRIORITY

The present application claims priority from Indian provisional application no. 202421079088, filed on October 17, 2024.

TECHNICAL FIELD

The disclosure herein generally relates to intercrop interaction, and, more particularly, to method and system to generate spatio-temporal intercrop layouts using 3D-CNN-LSTM based large vision model.

BACKGROUND

Crop diversification is a promising strategy for transitioning towards sustainable agricultural systems by leveraging biological processes and controls present in naturally biodiverse ecosystems. Agriculture industry is constantly evolving, adapting, and finding new ways to enhance growth and yield of crops. Intercropping pattern addresses global urgency to increase food production against a backdrop of decreasing cultivable land and environmental concerns. Intercropping is a sustainable agricultural practice which enhances efficient land use, soil fertility, and overall crop productivity. Intercropping also promotes biodiversity and a more balanced ecosystem. The presence of multiple plant species creates a habitat for beneficial insects like pollinators and pest predators, reducing reliance on insecticides. Additionally, a diversified plant cover helps suppress weed growth and minimize soil erosion. Significance of intercropping lies in its potential to create more resilient and sustainable agricultural systems. It offers increased yields, reduces reliance on external inputs, and promotes overall soil health. This is particularly important in the face of climate change and growing pressure to produce food more efficiently. This improves soil structure and water holding capacity of soil and reduces soil erosion and reduces incidence of insect pests, disease and weeds.

Existing techniques rely on agricultural extension consulting services where government or university-affiliated programs employs agronomists to provide agriculture land or site-specific advice based on local conditions, soil types, and common crops. Here, intercropping data is extracted manually from existing publications or online resources with successful intercropping practices in specific region. Such a technique is time consuming and requires manual effort.

In another existing technique universities and research institutions developed online decision-making web-based tools utilizes factors such as climate, soil fertility, and desired crops to recommend suitable intercropping partners. Such tools are developed based on available knowledge from field trials and experiments. Such technique limits in knowledge from field trials and do not cover all possible scenarios which are possible using data-driven approaches.

In another existing technique user connects with experienced farmers who already practiced intercropping to obtain insights on practical knowledge. Local farmer associations or online forums provide experienced individuals to share success stories and challenges related to specific intercropping combinations. Such technique is human driven and not accurate.

Moreover, such existing techniques robustly supports inter-cropping particularly cereal-legume, plan-crop or such combinations, as a means to enhance crop yields and improve soil health. Intercropping patterns and nutrient management address a critical need of reutilizing agricultural land for various characteristics related crops. However, existing techniques lack significant gap in providing specific impacts of various inter-cropping patterns, nutrient management strategies, inter crop combination and their spatio-temporal layout specifically in diverse agro-ecological zones. Moreover, pre-existing data on successful intercropping practices is limited for specific crops or regions. Also, they use static data (e.g., soil reports, historical yields) and lack the ability to capture dynamic changes throughout the growing season. Also, most of the techniques are on-farm trials which is timeconsuming and resource-intensive to implement across large areas.

SUMMARY

Embodiments of the present disclosure present technological improvements as solutions to one or more of the above-mentioned technical problems recognized by the inventors in conventional systems. For example, in one embodiment, a system to generate spatio-temporal intercrop layouts using 3D-CNN-LSTM based large vision model is provided. The system includes receiving a user request comprising a geotagged boundary of agriculture field and one or more user preferences of expected potential yield, a Greenhouse Gas (GHG) emissions, one or more sustainability scores and combination thereof. The user request is pre-processed by removing noise and normalization. Further, a pretrained 3D-CNN-LSTM based large vision model is utilized to generate an optimal spatio-temporal intercrop layout(s) for each intercropping scenario for the preprocessed user request by obtaining one or more user preferences of expected potential yield, the GHG emissions, one or more sustainability scores and combination thereof. Further, one or more intercrop combinations are recommended for the spatio-temporal intercrop layout based on the one or more user preferences. Furthermore, visual insights are dynamically provided for the spatio-temporal intercrop layout comprising crop growth and corresponding intercrop interaction. Finally, a user feedback is obtained by at least one of the user or non-invasively in response for the user request for iterative improvements and fine-tuning the 3D-CNN-LSTM model using reinforcement learning.

In another aspect, a method to generate spatio-temporal intercrop layouts using 3D-CNN-LSTM based large vision model is provided. The method includes to generate spatio-temporal intercrop layouts using 3D-CNN-LSTM based large vision model is provided. The method includes receiving a user request comprising a geotagged boundary of agriculture field and one or more user preferences of expected potential yield, a Greenhouse Gas (GHG) emissions, one or more sustainability scores and combination thereof. The user request is pre-processed by removing noise and normalization. Further, a pretrained 3D-CNN-LSTM based large vision model is utilized to generate an optimal spatio-temporal intercrop layout(s) for each intercropping scenario for the preprocessed user request by obtaining one or more user preferences of expected potential yield, the GHG emissions, one or more sustainability scores and combination thereof. Further, one or more intercrop combinations are recommended for the spatio-temporal intercrop layout based on the one or more user preferences. Furthermore, visual insights are dynamically provided for the spatio-temporal intercrop layout comprising crop growth and corresponding intercrop interaction. Finally, a user feedback is obtained by at least one of the user or non-invasively in response for the user request for iterative improvements and fine-tuning the 3D-CNN-LSTM model using reinforcement learning.

In yet another aspect, there are provided one or more non-transitory machine-readable information storage mediums comprising one or more instructions which when executed by one or more hardware processors cause to generate spatio-temporal intercrop layouts using 3D-CNN-LSTM based large vision model is provided. The method includes receiving a user request comprising a geotagged boundary of agriculture field and one or more user preferences of expected potential yield, a Greenhouse Gas (GHG) emissions, one or more sustainability scores and combination thereof. The user request is pre-processed by removing noise and normalization. Further, a pretrained 3D-CNN-LSTM based large vision model is utilized to generate an optimal spatio-temporal intercrop layout(s) for each intercropping scenario for the preprocessed user request by obtaining one or more user preferences of expected potential yield, the GHG emissions, one or more sustainability scores and combination thereof. Further, one or more intercrop combinations are recommended for the spatio-temporal intercrop layout based on the one or more user preferences. Furthermore, visual insights are dynamically provided for the spatio-temporal intercrop layout comprising crop growth and corresponding intercrop interaction. Finally, a user feedback is obtained by at least one of the user or non-invasively in response for the user request for iterative improvements and fine-tuning the 3D-CNN-LSTM model using reinforcement learning.

It is to be understood that both the foregoing general description and the following detailed description are exemplary and explanatory only and are not restrictive of the invention, as claimed.

BRIEF DESCRIPTION OF THE DRAWINGS

The accompanying drawings, which are incorporated in and constitute a part of this disclosure, illustrate exemplary embodiments and, together with the description, serve to explain the disclosed principles:

FIG.1 is a schematic view of an environment where a system is deployed to generate an spatio-temporal intercrop layout(s) for crop combinations, in accordance with some embodiments of the present disclosure.

FIG.2A is a functional block diagram of a system to generate spatio temporal intercrop layout for crop interaction, in accordance with some embodiments of the present disclosure.

FIG.2B depicts process flow of the system for spatio-temporal intercrop layout, in accordance with some embodiments of the present disclosure.

FIG.3 is a flow diagram illustrating a method for generating spatio-temporal intercrop interaction layout for crop combinations using the system of FIG. 1, in accordance with some embodiments of the present disclosure.

FIG.4A depicts a use case example of intercropping interaction scenario simulation module 210d which identifies compatible intercrops using the system of FIG.2A, in accordance with some embodiments of the present disclosure.

FIG.4B depicts a spatio-temporal interaction of crops (C1,C2) at different time intervals (T1,T2,T3) using the system of FIG.2A, in accordance with some embodiments of the present disclosure.

FIG.4C depicts a use case example output intercrop layout for compatible crops using the system of FIG.2A, in accordance with some embodiments of the present disclosure.

FIG.5 depicts a predicted intercrop interaction layout for the use case example at different time intervals using the system of FIG.2A, in accordance with some embodiments of the present disclosure.

DETAILED DESCRIPTION OF EMBODIMENTS

Exemplary embodiments are described with reference to the accompanying drawings. In the figures, the left-most digit(s) of a reference number identifies the figure in which the reference number first appears. Wherever convenient, the same reference numbers are used throughout the drawings to refer to the same or like parts. While examples and features of disclosed principles are described herein, modifications, adaptations, and other implementations are possible without departing from the scope of the disclosed embodiments.

**GLOSSARY:**

As used herein the term "cropping pattern" refers to proportion of area under various crops at a point of time in a unit area. It indicates the yearly sequence and spatial arrangement of crops and fallow in an area. It also involves how crops are cultivated over a growing season, including crop rotation, mixed cropping, intercropping.

The term "Intercropping" is an agricultural system that improves land use efficiency through simultaneous cultivation of more different crops in the same field, where crop one (C1) may be called primary or main crop and crop two (C2) as secondary or sub crop.

"Intercropping interaction" refers to response of one crop to the environment as modified by the presence of another crop. It refers to dynamic relationships between different crops grown together in same field. These interactions can be either beneficial, neutral or competitive depending on how the crops affect each other in terms of resources use (light, water, nutrients) and overall growth.

"Crop layout" refers to a plan according to which crops are grown on individual plot of a farm during a given period of time with the object of obtaining maximum return from each crop without impairing soil fertility.

Intercropping is a sustainable agricultural practice, and is pivotal in enhancing land use efficiency, soil fertility, and overall crop productivity. Here, two or more crops are grown in close proximity during same growing season. This can involve planting them in mixed rows, alternating strips, or even planting one crop beneath a taller, maturing crop. While there are many advantages of cultivating intercrops, intercultural operations and harvesting with the help of machinery are difficult, and there is an increased competition among the resources. It requires careful planning and management to select compatible crops and their spatial arrangement to manage potential competition and get the maximum outcome.

Existing intercropping recommendations for a given user request provides static recommendations based on pre-defined parameters, where there is a dynamic requirement in agriculture considering few factors such as unpredictable weather events, fluctuations in market prices, and pest outbreaks can necessitate adjustments to intercropping plans. Accurately simulating complex interactions between different crops in intercropping is challenging. These interactions involve competition for resources such as sunlight, water, and nutrients, as well as potential benefits like pest suppression and nitrogen fixation. Existing tools do not capture such traces. Also, existing techniques lack in providing optimal spatial layout or arrangement of recommended crops as intercrops. Also, available experimental or field trial data is limited due to huge amount of effort and costs associated with analyzing such interactions to select optimal combination/s.

Embodiments of the present disclosure provide a method and system to generate spatio-temporal intercrop layouts using 3D-CNN-LSTM based large vision model. Spatio-temporal interaction model leverages a 3D Convolutional Neural Network (CNN) combined with a Long Short-Term Memory (LSTM) network to capture both spatial and temporal dynamics in agricultural data. This hybrid framework enables precise analysis and prediction of crop interactions over time making it an effective tool for recommending optimal intercropping strategies. The 3D-CNN-LSTM based large vision model is pretrained on historical data encompassing various environmental conditions, crop types, and management practices, ensuring robust and adaptable recommendations. The method is capable of generating spatio-temporal intercrop layout for crop combinations for a given user request using a pretrained three dimensional convolutional neural network long short term memory based large vision model (3D-CNN-LSTM) and may be alternatively referred as 3D-CNN-LSTM. The spatio-temporal intercrop layout provides crop growth cycle at varying timelines feasible to intercrop combination of the agricultural field, and corresponding interactions based on agro-climatic, geographic, and farming practices. The method utilizes a sophisticated pre-trained spatio-temporal interaction 3D-CNN-LSTM model to recommend optimal intercrop combinations. Moreover, the method combines crops with different nutrient needs and root structures, intercropping allows for a more complete capture of sunlight, water, and minerals from the soil. Additionally, some plants, like legumes, can fix nitrogen from the air, enriching the soil for neighboring crops and reducing the need for synthetic fertilizers. Also, the method is efficient and scalable utilizing available agriculture resources for maximum crop yield with balanced crop nutrients.

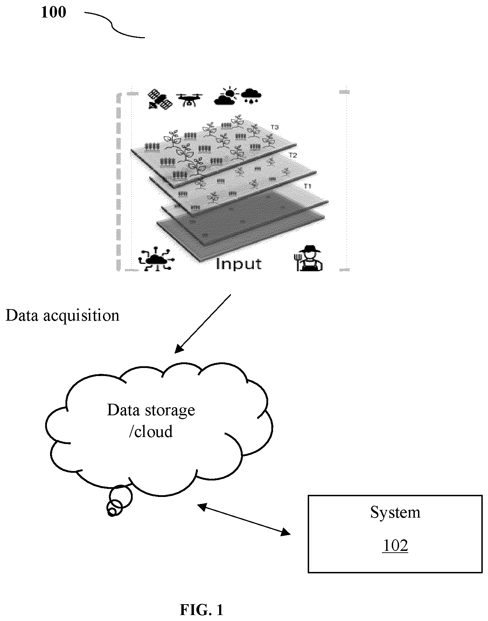

Referring now to the drawings, and more particularly to FIG.1 through FIG.5, where similar reference characters denote corresponding features consistently throughout the figures, there are shown preferred embodiments and these embodiments are described in the context of the following exemplary system and/or method.

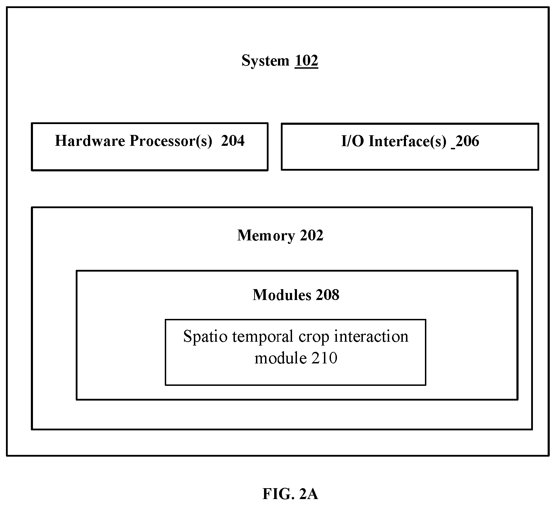

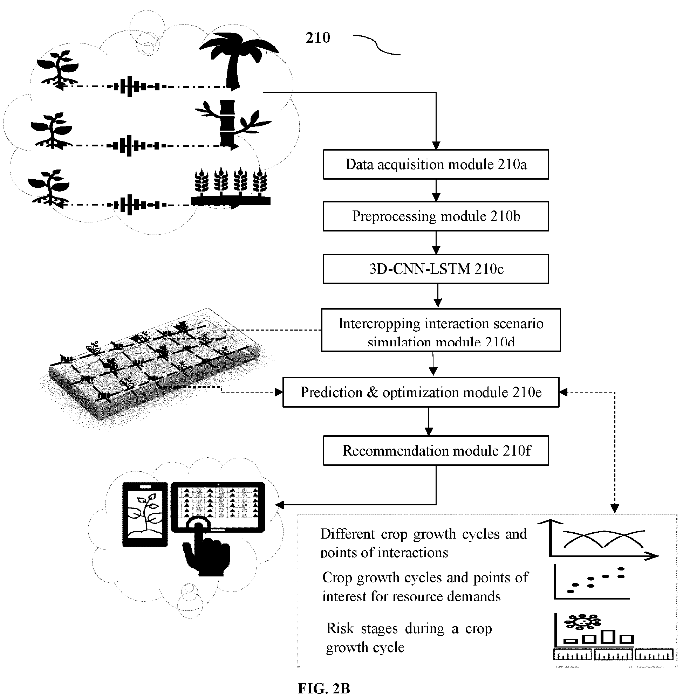

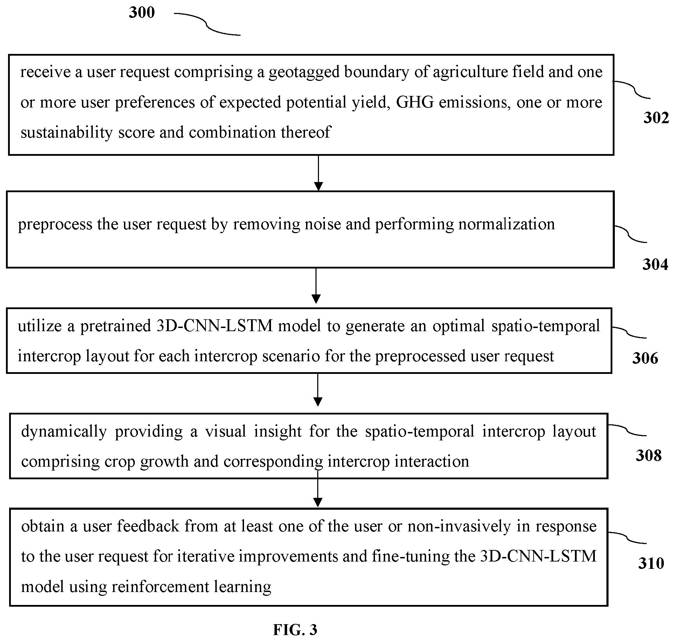

FIG.1 is a schematic view of an environment 100 where a system 102 is deployed to generate an spatio-temporal intercrop layout for crop combinations, in accordance with some embodiments of the present disclosure. The FIG. 1 depicts an input data received from a plurality of agriculture fields, where each agriculture field also referred to as land of interest of user. High-resolution imaging devices such as satellite imaging systems, unmanned aerial vehicles (UAV) such as drone with high-resolution cameras, autonomous tractors and harvesters, and other unmanned ground vehicles (UGV) like but not limited to, rovers, captures data for an coverage area of user agriculture field. The system 102 with techniques known in the art can geo tag user agriculture field to identify boundaries of each field or the land of interest. Additionally, each field has deployed sensors that directly communicate with a cloud server through which respective farmers or landowners obtains response for the request. For example, soil and water sensors, such as but not limited to, soil moisture, temperature, organic carbon sensors, soil and plant nutrient sensors, and weather stations for local weather data collection. The system 102 is further explained with respect to FIG.2A and FIG.2B and method depicted in flow diagram of FIG.3.

FIG.2A is a functional block diagram of a system to generate spatio-temporal intercrop layout for crop interaction, in accordance with some embodiments of the present disclosure. In an embodiment, the system 102 includes a processor(s) 204, communication interface device(s), alternatively referred as input/output (I/O) interface(s) 206, and one or more data storage devices or a memory 202 operatively coupled to the processor(s) 204. The system 102 with one or more hardware processors is configured to execute functions of one or more functional blocks of the system 102.

Referring to the components of the system 102, in an embodiment, the processor(s) 204, can be one or more hardware processors 204. **In** an embodiment, the one or more hardware processors 204 can be implemented as one or more microprocessors, microcomputers, microcontrollers, digital signal processors, central processing units, state machines, logic circuitries, and/or any devices that manipulate signals based on operational instructions. Among other capabilities, the one or more hardware processors 204 are configured to fetch and execute computer-readable instructions stored in the memory 202. In an embodiment, the system 102 can be implemented in a variety of computing systems including laptop computers, notebooks, hand-held devices such as mobile phones, workstations, mainframe computers, servers, and the like.

The I/O interface(s) 206 can include a variety of software and hardware interfaces, for example, a web interface, a graphical user interface to display generated intercrop layout and the like and can facilitate multiple communications within a wide variety of networks N/W and protocol types, including wired networks, for example, LAN, cable, etc., and wireless networks, such as WLAN, cellular and the like.

In an embodiment, the I/O interface (s) 206 can include one or more ports for connecting to a number of external devices or to another server or devices. The memory 202 may include any computer-readable medium known in the art including, for example, volatile memory, such as static random access memory (SRAM) and dynamic random access memory (DRAM), and/or non-volatile memory, such as read only memory (ROM), erasable programmable ROM, flash memories, hard disks, optical disks, and magnetic tapes.

In an embodiment, the memory 202 includes a plurality of modules 210 such as a spatio temporal crop interaction module for generating intercrop layout for user request. Here, spatio temporal crop interaction module is trained with 3D CNN model for determining compatibility between main crop and sub crops. Crops may include sugarcane, coconut, wheat, seasonal crops and combination thereof etc., having healthy nutrient management. It is noted that the main crop and sub crops list can vary from region to region based on requirement provided by the user agriculture field.

The plurality of modules 210 include programs or coded instructions that supplement applications or functions performed by the system 102 for executing different steps involved in the process of generating intercrop layout, being performed by the system 102. The plurality of modules 210, amongst other things, can include routines, programs, objects, components, and data structures, which performs particular tasks or implement particular abstract data types. The plurality of modules 210 may also be used as, signal processor(s), node machine(s), logic circuitries, and/or any other device or component that manipulates signals based on operational instructions. Further, the plurality of modules 210 can be used by hardware, by computer-readable instructions executed by the one or more hardware processors 104, or by a combination thereof. The plurality of modules 210 can include various submodules (not shown).

Further, the memory 102 may comprise information pertaining to input(s)/output(s) of each step performed by the processor(s) 104 of the system 102 and methods of the present disclosure. Further, the memory 202 includes a database. The database (or repository) may include a plurality of abstracted piece of code for refinement and data that is processed, received, or generated as a result of the execution of the plurality of modules in the module(s) 210. Although the database 208 is shown internal to the system 102, it will be noted that, in alternate embodiments, the database 208 can also be implemented external to the system 102, and communicatively coupled to the system 102. The data contained within such external database may be periodically updated. For example, new data may be added into the database (not shown in FIG.2A) and/or existing data may be modified and/or non-useful data may be deleted from the database. In one example, the data may be stored in an external system, such as a Lightweight Directory Access Protocol (LDAP) directory and a Relational Database Management System (RDBMS). Functions of the components of the system 102 are now explained with reference to FIG.2B through steps of flow diagram in FIG.3.

FIG.2B depicts process flow of the system for spatio-temporal intercrop layout, in accordance with some embodiments of the present disclosure. The FIG.2B depicts spatio-temporal crop interaction module 210 comprising a data acquisition module 210a where an user request is obtained as inputs to provide spatio-temporal intercrop layout by identifying compatible crops. Here, a set of user inputs provided by the user associated with the user request is received in time-series, high-resolution satellite imagery data, drone imagery data, soil properties, sowing dates, GHG emissions, sustainability scores, and weather data.

For the user request, a preprocessing module 210b preprocesses the set of user inputs by removing noise and performing normalization. This module standardizes formats, removes noise, and enhances relevant features while additional data is normalized for consistency and comparability.

Further, a pre-trained 3D-CNN-LSTM module 210c fetches the preprocessed input data to generate an spatio-temporal intercrop layout for each intercropping scenario. This module analyzes spatial interactions and temporal interactions between different crop species throughout the growing season by extracting at least one spatial features and temporal features of each inter-crop interaction to predict intercropping outcome.

Further, a intercropping interaction scenario simulation module 210d recommends one or more intercropping combinations and generates a spatio-temporal layout based on spatial interactions and temporal interactions and user preferences. Here, the one or more user preferences includes user goals, desired outcome, crop yields estimate, GHG, and sustainability scores for varying intercropping scenarios.

In addition, a prediction & optimization module 210e provides different crop growth cycles and points of interactions for each crops associated with the spatio-temporal layout. This includes output on maximizing yield, minimizing environmental impact, goals comparison with each simulated scenario.

Finally, a recommendation module 210f provides dynamic insights for the spatio-temporal layout which includes spatio-temporal crop growth and their interaction as response to the user request. Also, it identifies intercrop compatible combinations considering static factors (such as soil properties) and dynamic interactions (such as crop competition and synergy throughout the growing season). The spatio-temporal layout is projected as output with visual simulations of the predicted growth cycles are delivered to users/farmers (through app or APIs) to aid decision-making and strategic planning for optimal intercropping practices.

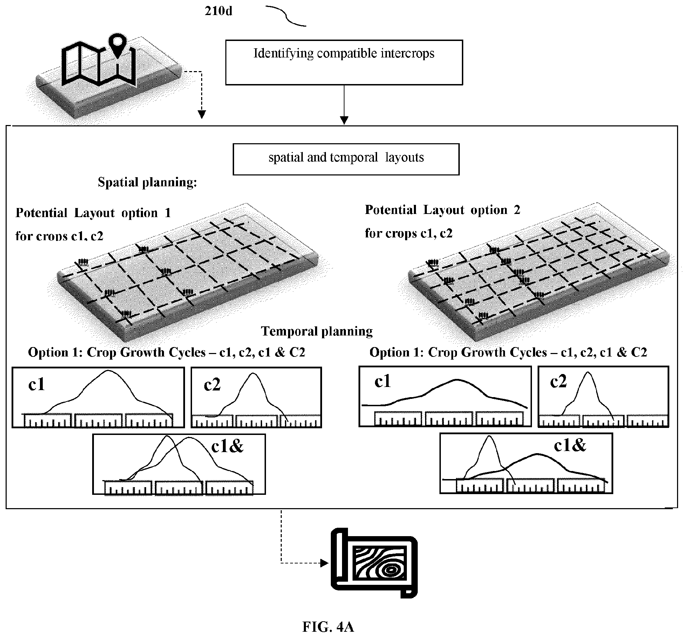

FIG.3 is a flow diagram illustrating a method 300 for generating spatio-temporal intercrop interaction layout for crop combinations using the system of FIG. 1, in accordance with some embodiments of the present disclosure. In an embodiment, the system 102 comprises one or more data storage devices or the memory 202 operatively coupled to the processor(s) 204 and is configured to store instructions for execution of steps of the method 300 by the processor(s) or one or more hardware processors 204. The steps of the method 300 of the present disclosure will now be explained with reference to the components or blocks of the system 102 as depicted in FIG.2A, FIG.2B, the steps of flow diagram as depicted in FIG.3 and a use case example in FIG.4A through FIG.5. Although process steps, method steps, techniques or the like may be described in a sequential order, such processes, methods, and techniques may be configured to work in alternate orders. In other words, any sequence or order of steps that may be described does not necessarily indicate a requirement that the steps to be performed in that order. The steps of processes described herein may be performed in any order practical. Further, some steps may be performed simultaneously.

Referring to FIG.2B and the steps of the method 300, at step 302 of the method 300, the one or more hardware processors 204 receives a user request comprising a geotagged boundary of agriculture field and one or more user preferences of expected potential yield, a GHG emissions, one or more sustainability scores and combination thereof.

Referring to an example as depicted in FIG.4A, where a user request comprises, inputs provided by the user to identify compatible intercrops for a given agriculture field. User provided intercrop may be a primary crop and sub-crops may be one or more compatible crops suitable for the user agriculture field. For example, the user request may be a row of "the primary crop", growing between sub crops without affecting optimum plant population as well as yield of the primary crop (base crop) or growing two or more crops (subcrops) simultaneously on the same agriculture land with distinct row arrangement such as Maize + Pigeon pea (2:1), Sorghum + Pigeon pea (2:1), Cotton + Green gram (2:1), Pigeon pea + Ground nut + Lentil (2:1:1), where the number in the bracket indicates the ratio of no. of lines of the crops. in addition to yield of major crop some extra intercrop yield (bonus crop) is obtained. In addition, intercropping of groundnut or vegetables in sugarcane or pulse or oilseed crops in sorghum or bajra and the like.

For the agriculture field associated with the user request, the system initially collects high-resolution satellite and drone imagery data over time along with additional agronomic factors such as soil properties, sowing dates, farm operations, greenhouse gas emissions and the like. The user request inputs may include geotagged boundary of the agriculture field and from which additional inputs such as soil properties, climatic conditions and the like are obtained. Here, each crop have different characteristics which varies with healthy water but not limited to nutrient management, water management, pest and disease management, recovery from weather disaster and the like.

At step 304 of the method 300, the one or more hardware processors 204 preprocesses the user request by removing noise and performing normalization.

The set of user inputs associated with the user request is preprocessed for format standardization, noise removal for extraction of relevant features in next step 306. For example, initially noise is removed from the user request by, simplification of complex geometries using spatial analysis techniques and removal of sliver polygons. Further, normalization includes conversion of user provided field boundary to standard format.

Spatial analysis techniques may include Douglas -Peucker algorithm, topology correction, polygon smoothing, buffering and erosion, point clustering and the like. Douglas-Peucker algorithm simplifies geometries by reducing number of vertices while preserving the shape. Topology correction ensures that there are no self-intersections, overlaps or gaps between polygons. Polygon smoothing applies smoothing algorithms to make boundary lines less jagged using methods such as B-spline. Buffering and erosion buffers the polygon boundaries slightly to remove small imperfections or outlier points. Point clustering aggregates closely located vertices to reduce the complexity of the geometry.

Normalization provides standard format of the user field boundaries by transforming input data into consistent coordinate reference system (CRS) ensuring geometry validation to correct any errors such as self-intersections. Attributes such as field ID, area units and boundary precision are standardized and the input data is converted to GeoJSON or shapefile format.

At step 306 of the method 300, the one or more hardware processors 204 utilizes a pretrained 3D-CNN-LSTM model to generate an optimal spatio-temporal intercrop layout for each intercropping scenario for the preprocessed user request.

Once the user request is preprocessed, the normalized data is then inputted into the pretrained 3D-CNN-LSTM model to extract at least one spatial features and at least one temporal features which analyzes spatio-temporal interactions between different crop species throughout the growing season.

In one embodiment, the 3D-CNN-LSTM model is pretrained by generating a training dataset with data collected from one or more agriculture fields for a predefined time from at least one of drone imagery data and high-resolution satellite imagery data. Training dataset comprises inputs obtained from at least one of satellite images, farm operations, weather but not limited to soil, water, and crop information. Training dataset includes historical data obtained from least one of the drone imagery data and the high-resolution satellite imagery data from sources like, but not limited to Sentinel-2, Landsat-8, and MODIS drone imagery over multiple time points and detailed information on various crop development stages such as crop types, intercropping patterns, crop interactions, and land use along with supplementary data such as soil properties, sowing dates, weather conditions, greenhouse gas emissions, and sustainability scores, geotagged location of the farm, soil properties of the farm, historical data, actual and forecasted weather, regional data on intercrops.

Further, the training dataset is preprocessed by removing noise using a noise removal technique such as median filtering, Gaussian smoothing, and Fourier transforms to eliminate atmospheric interference, sensor noise, and other artifacts. Moreover, feature enhancement is performed using histogram equalization, edge detection, or normalization to improve image quality and contrast. Supplementary data also undergoes standardization and normalization using methods like Z-score normalization to ensure consistency and uniformity.

Further, the method is trained to extract one or more spatio-temporal features from the preprocessed dataset comprising (i) a spatial distribution and interactions of crops across time for identifying patterns and relationships in spatial domain, and (ii) an temporal dimension to track changes and trends.

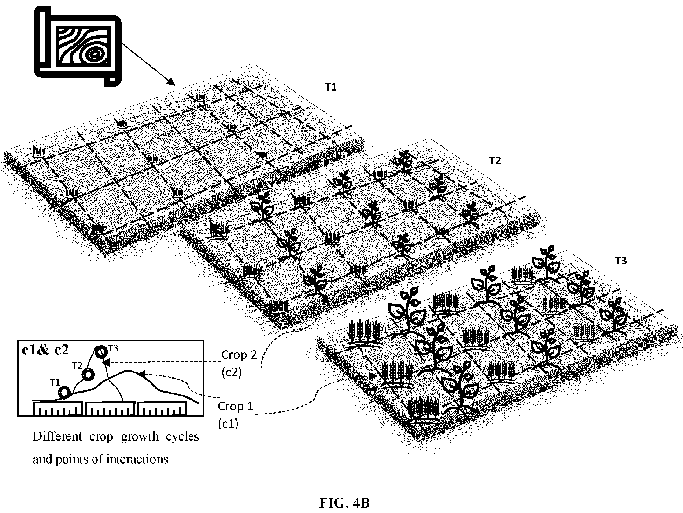

To generate the spatio-temporal intercrop layout provides recommendations for one or more intercrop combinations matching user preferences, (referring now back to FIG.4B and the user request) for the preprocessed inputs from previous step, the one or more spatio-temporal features are extracted. Here, a spatio-temporal interaction of crops (C1,C2) at different time intervals (T1,T2,T3) is depicted in FIG.4B for the above example. Here, crop interaction is function of = $f(C_1 \& C_2 ... upto C_n)$ time-they spent together, Space they share i.e. area and distance) + f(environment such as agroclimatic zone, soil characteristics, water quality, etc.). The one or more spatial feature includes vegetation indices such as NDVI and EVI from satellite imagery, vegetation growth in relation to soil moisture, vegetation growth in relation to nutrient uptake, canopy density, crown coverage, overlap between canopies estimated from remote sensing, rate of increase in leaf area index but not limited to soil properties such as pH, organic content, and moisture from soil maps, remote sensing, and topographical features such as elevation, slope, and aspect from digital elevation models (DEMs) to understand terrain influences on crop growth. Additionally, the model analyzes crop canopy coverage and spatial arrangement to evaluate the distribution of crops within the field.

Further, the method extracts one or more temporal features from time-series data from Long Short-Term Memory (LSTM) networks which includes timing of crop growth stages of each crop to monitor crop growth stages over time, temperature spikes, rainfall patterns to assess the impact of weather events throughout the growing season, sequence and timing of agronomic inputs like fertilizer, irrigation, pesticide and seasonal trends variations that influence crop interactions across multiple seasons. The one or more flattened spatial features are input to the LSTM layer to capture temporal dynamics of crop interactions. The LSTM hidden states retain information about past interactions allowing the model to predict future interactions based on the historical data. Fully connected layers are then mapped into spatio-temporal features to specific outcomes such as crop yield, greenhouse gas emissions, and sustainability scores. The 3D-CNN-LSTM model further predicts outcomes for various intercropping scenarios providing comprehensive evaluation of each potential combination. Users can input their desired outcomes where the system compares predicted outcomes with goals to recommend compatible intercropping combinations.

Once the one or more spatial features and the one or more temporal features are extracted from the above step, the one or more spatio-temporal features are concatenated using the 3D-CNN-LSTM model to form a comprehensive feature map which represents spatio-temporal interactions. The 3D-CNN processes the one or more spatial features to identify relationships and patterns between different crops and their environment. LSTM processes sequential temporal data to derive the one or more temporal features to capture time-dependent dynamics of crop growth and interaction.

Then, a crop interaction score for the one or more concatenated spatio-temporal features is determined based on a degree of influence one crop exerts on another considering spatial proximity and temporal growth patterns. The crop interaction score includes combination of the spatial interaction score derived from a spatial feature map using the output obtained from 3D-CNNs and the temporal interaction score derived from a temporal feature map based on synchronization timing of crop growth stages using the output obtained from the LSTM. The crop interaction scores are used to quantify the degree of competition or synergy between crops when they are grown together. These scores can be derived based on observed or simulated data for resource use (e.g., water, light, nutrients). Table 1 below is an example of the crop interaction score calculation for water competition.

Table 1 - Crop interaction score calculation for water competition

The crop interaction score is an interaction-weighted loss function of the spatial interaction score and the temporal interaction score to emphasize specific interactions. The spatial interaction score is computed using the 3D Convolutional Neural Network (CNN) by analyzing spatial distribution of crops and their interactions within a given area. This involves identifying patterns such as resource sharing, competition, or complementarity in nutrient usage, water absorption, or sunlight capture between neighboring crops. The CNN extracts these spatial features by applying convolutional operations across the spatial dimensions (x, y) over a series of

---

Step 1: Data Collection
  Measure soil moisture content at various depths in the field throughout the growing season.
  Monitor the water uptake rate of each crop in an intercrop system using soil moisture sensors or lysimeters.
  Record precipitation, irrigation, and evapotranspiration data.
Step 2: Baseline Water Use Efficiency (WUE)
  - Calculate the baseline WUE for each crop in a monoculture system (i.e., when grown alone).
  - WUE = (Crop Yield) / (Water Used)
Step 3: Calculate Water Uptake
  For each time step, calculate the actual water uptake by each crop in the intercrop system. Consider the root distribution and depth to estimate how much water each crop is extracting from different soil layers.
Step 4: Interaction Score Calculation
  Interaction Score (Water Competition) = (Observed WUE in Intercrop) / (Baseline WUE in Monoculture)
  If the score > 1, it suggests a synergistic effect where crops use water more efficiently together.
  If the score < 1, it indicates competition where one or both crops use water less efficiently when grown together.
Step 5: Adjust for Temporal Dynamics - Analyse how the interaction score changes over time, particularly during critical growth stages (e.g., flowering, grain filling).
  This temporal analysis helps to understand when competition or synergy is most pronounced.
Step 6: Aggregate Scores - Aggregate interaction scores across different resources (e.g., water, light, nutrients) to get an overall interaction score for the crop pair.

---

time frames (z) thus capturing local spatial dependencies between crops in the intercropping database. The temporal interaction score is computed using Long Short-Term Memory (LSTM) networks which model changes and progression of crop interactions over time. By feeding the extracted spatial features from the 3D-CNN into LSTM layers, the model captures interactions occurring between crops throughout different growth stages and across seasons. Further, LSTM keeps track of past interactions allowing to learn temporal dependencies such as the effect of early stage resource competition on later yield or long-term benefits of complementary crops. Further, the final output layer predictions are adjusted and re-weighted with feature importance and temporal sequences are modeled dynamically for future predictions using the spatio-temporal crop interaction score.

Finally, the spatio-temporal crop layout provides simulations of crop interaction which will be provided to the user/ farmers helping to visualize complete growth cycle of crops which would help them in better decision making.

In one embodiment, the spatio-temporal features are refined using dimensionality reduction and flattening for temporal sequence modeling. The 3D-CNN-LSTM model is learned using the refined spatio-temporal features by

modifying an interaction-weighted loss function between crops and their corresponding agriculture field. After training, the model adjusts its predictions based on learned interactions between crops and their environment. The output layer shall reflect the adjustments. The re-weighted feature importance affects how temporal sequences are modeled in future predictions. The model dynamically adjusts how it processes the temporal data (such as the crop growth stages) based on the newly emphasized spatial and temporal interactions. This ensures that the model continues to learn and adapt as new data. The interaction-weighted loss function is determined using the spatial interaction score and the temporal interaction score for specific interactions, and final output layer predictions are adjusted by re-weighting the crop interaction score to improve accuracy. For example, if certain spatial features (e.g., distance between crops) are found to be more influential for one crop than another, these features are given higher weights.

The interaction-weighted loss function is modified using two key inputs, the spatial interaction score and the temporal interaction score. These scores are derived from the interaction between crops in terms of spatial proximity (distance, orientation, etc.) and temporal growth patterns (growth stages, crop cycles, etc.). The spatial interaction score and the temporal interaction score interaction scores are used as weights in the loss function. For example, an interaction-weighted cross-entropy loss function could be used, where the weights are derived from these interaction scores, giving more importance to certain interactions (based on proximity and growth impact). For example, **Cross-Entropy Loss:** This is commonly used for classification tasks, measuring the difference between the predicted and actual class probabilities (Standard formula for cross Entropy Loss which we are modifying based on interaction weights) is given below in Equation 1,

$$L = -\sum_{i=1}^{n} y_i \log(p_i) \text{ --- Equation 1}$$

Where, L is the loss, $y_i$ is actual class label (either 0 or 1 for binary classification) and $p_i$ is predicted probability for class 1. **Interaction weighted cross entropy loss:** The spatial interaction score and the temporal interaction score can serve as weights in the loss function. For example, interactions between crops that are more significant (either due to proximity or temporal alignment) would have a higher weight meaning the model gives more emphasis to correctly predicting those interactions during training as described below in Equation 2,

$$L_{interaction-weighted} = -\sum_{i=1}^{n} w_i * y_i \text{ --- Equation 2}$$

Here, $w_i$ is the interaction weight for ith sample which could be derived from the interaction scores between crops or other spatial/temporal features If the interaction between certain crops is found to be more important, the corresponding $w_i$ will be higher, leading to stronger influence on the loss calculation.

The interaction-weighted loss is modified in an iterative process during training. Modifications are made based on the model's performance in learning the relationships between crops. The modification of the loss function can be triggered at certain conditions during model training. For example, if the model starts overfitting to non-interaction-based patterns or if specific interactions between crops are found to have high predictive value, the loss function can be adjusted to give more weight to those interactions. For example, triggers may include High interaction score: When the interaction score between two crops reaches a certain threshold, the loss function may apply more weight to predictions involving these interactions. Misclassification patterns: If the model consistently misclassifies instances with high interaction scores, the weights could be increased to force the model to pay more attention to those patterns.

Referring now at step 308 of the method 300, the one or more hardware processors 204 dynamically provides visual insights for spatio-temporal intercrop layout comprising crop growth and corresponding intercrop interaction. Finally, the method generates visual simulations of the recommended strategies, showing predicted growth cycles and interactions over time. These simulations are provided to farmers, enabling them to visualize the effects of different intercropping combinations and make informed decisions. This spatio-temporal interaction model offers a comprehensive analysis by integrating spatial and temporal data, personalized recommendations by incorporating user-specified goals, and dynamic adjustments by capturing temporal dynamics, making it a significant advancement in precision agriculture.

At step 310 the method 300, the one or more hardware processors 204 obtains feedback from the user non-invasively in response to the user request for iterative improvements and fine-tuning the 3D-CNN-LSTM model using reinforcement learning.

Finally, visualization tools and farmer feedback is obtained as input. Interactive maps and visual simulations of the spatio-temporal layouts are generated, allowing farmers to visualize the complete growth cycle of crops under the recommended arrangements. User provided feedback is finetuned for refinement. The method is an user-friendly interface for farmers to input their specific goals and preferences, and field validation guidance is provided to enable effective implementation of the optimized intercropping strategies.

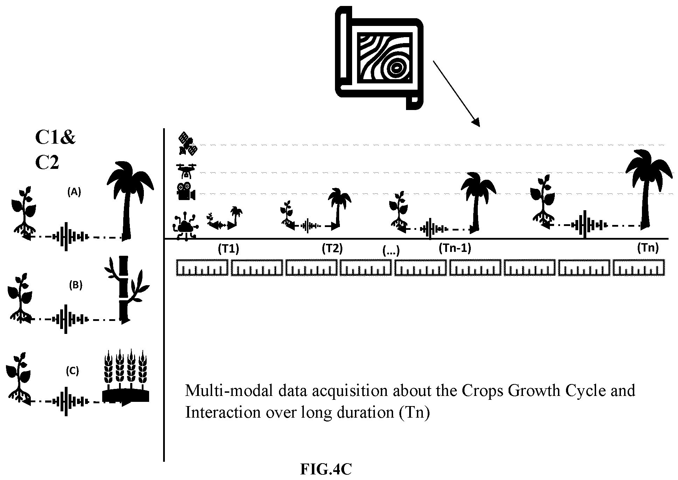

FIG.4B and FIG.4C as described for the example simulated experimental results for generation of optimal spatio-temporal layouts for intercropping which initiates data ingestion and preprocessing. This involves collecting comprehensive data on crop characteristics such as growth stages, nutritional needs, and physical attributes. Additionally, data on soil properties includes composition, moisture levels, pH, and nutrient content along with short-term and long-term weather forecasts that detail temperature, precipitation, and sunlight intensity. Provided data is further preprocessed to ensure compatibility with AI model by standardization of data formats and normalization of numerical values are crucial to maintaining consistent scaling across different input parameters. The core of AI model integrates a pre-trained large vision model (LVM) which analyzes historical imagery or typical canopy structures. This model includes crop growth modules which simulates development of individual crops based on the ingested data, soil-water-plant relationship models to predict water usage and nutrient uptake. A competition sub-model is also included to simulate the competition for resources such as light, water, and nutrients among different crops. This comprehensive model setup enables a detailed simulation of intercropping scenarios. The LVM is utilized to simulate light interception by crop canopies under various planting configurations followed by simulations of crop growth and yield for user-defined scenarios. These simulations account for competition among crops for essential resources. The model generates spatial maps that illustrate zones of competition and resource utilization across the field, and analyzes how these zones change over time, providing insights into the dynamic interactions between crops throughout the growing season.

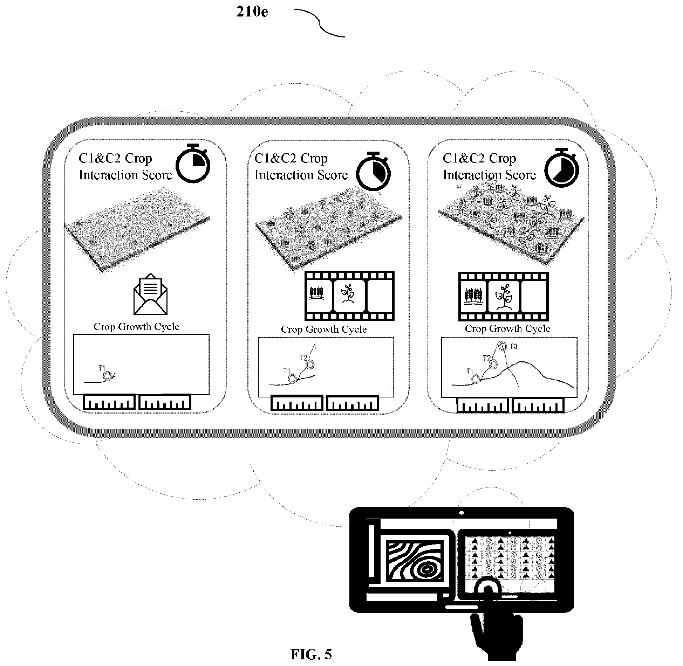

FIG.5 depicts a predicted intercrop interaction layout for the use case example at different time intervals using the system of FIG.2A, in accordance with some embodiments of the present disclosure.

For the above example as depicted in FIG.4B, FIG.4C prediction and recommendation follows simulation phase where the model predicts yields and resource use including water and nutrients for each simulated scenario and calculates sustainability metrics such as greenhouse gas emissions and soil health indicators. Based on these predictions, the method recommends optimal spatial arrangement of crops that maximizes yield and resource use efficiency. It also offers users the ability to explore different planting scenarios and their predicted outcomes.

The written description describes the subject matter herein to enable any person skilled in the art to make and use the embodiments. The scope of the subject matter embodiments is defined by the claims and may include other modifications that occur to those skilled in the art. Such other modifications are intended to be within the scope of the claims if they have similar elements that do not differ from the literal language of the claims or if they include equivalent elements with insubstantial differences from the literal language of the claims.

The embodiments of present disclosure herein addresses unresolved problem of intercrop interaction. The embodiment, thus provides method and system to generate spatio-temporal intercrop layouts using 3D-CNN-LSTM based large vision model. Moreover, the embodiments herein further provides crop diversification, prediction and recommendation for intercropping interaction. The method provided technical advantages by integrating multi-crop models and algorithms based on incorporating data from various sources such as (e.g., sensors, drones, weather stations) resulting efficient crop interactions and resource competition. The system is flexible to be deployed in adaptive advisory applications which provides user-friendly interfaces and decision support tools. Moreover, the method is robust ensuring data quality and data management systems. Intercropping offer benefits like improved soil health, increased biodiversity, and reduced pests and diseases. Careful planning, management, and crop selection can help mitigate these challenges and make intercropping a successful and sustainable farming practice.

It is to be understood that the scope of the protection is extended to such a program and in addition to a computer-readable means having a message therein; such computer-readable storage means contain program-code means for implementation of one or more steps of the method, when the program runs on a server or mobile device or any suitable programmable device. The hardware device can be any kind of device which can be programmed including e.g., any kind of computer like a server or a personal computer, or the like, or any combination thereof. The device may also include means which could be e.g., hardware means like e.g., an applicationspecific integrated circuit (ASIC), a field-programmable gate array (FPGA), or a combination of hardware and software means, e.g., an ASIC and an FPGA, or at least one microprocessor and at least one memory with software processing components located therein. Thus, the means can include both hardware means and software means.

The method embodiments described herein could be implemented in hardware and software. The device may also include software means. Alternatively, the embodiments may be implemented on different hardware devices, e.g., using a plurality of CPUs.

The embodiments herein can comprise hardware and software elements. The embodiments that are implemented in software include but are not limited to, firmware, resident software, microcode, etc. The functions performed by various components described herein may be implemented in other components or combinations of other components. For the purposes of this description, a computerusable or computer readable medium can be any apparatus that can comprise, store, communicate, propagate, or transport the program for use by or in connection with the instruction execution system, apparatus, or device.

The illustrated steps are set out to explain the exemplary embodiments shown, and it should be anticipated that ongoing technological development will change the manner in which particular functions are performed. These examples are presented herein for purposes of illustration, and not limitation. Further, the boundaries of the functional building blocks have been arbitrarily defined herein for the convenience of the description. Alternative boundaries can be defined so long as the specified functions and relationships thereof are appropriately performed. Alternatives (including equivalents, extensions, variations, deviations, etc., of those described herein) will be apparent to persons skilled in the relevant art(s) based on the teachings contained herein. Such alternatives fall within the scope of the disclosed embodiments. Also, the words "comprising," "having," "containing," and "including," and other similar forms are intended to be equivalent in meaning and be open ended in that an item or items following any one of these words is not meant to be an exhaustive listing of such item or items, or meant to be limited to only the listed item or items. It must also be noted that as used herein and in the appended claims, the singular forms "a," "an," and "the" include plural references unless the context clearly dictates otherwise.

Furthermore, one or more computer-readable storage media may be utilized in implementing embodiments consistent with the present disclosure. A computer-readable storage medium refers to any type of physical memory on which information or data readable by a processor may be stored. Thus, a computer-readable storage medium may store instructions for execution by one or more processors, including instructions for causing the processor(s) to perform steps or stages consistent with the embodiments described herein. The term "computer-readable medium" should be understood to include tangible items and exclude carrier waves and transient signals, i.e., be non-transitory. Examples include random access memory (RAM), read-only memory (ROM), volatile memory, nonvolatile memory, hard drives, CD ROMs, DVDs, flash drives, disks, and any other known physical storage media.

It is intended that the disclosure and examples be considered as exemplary only, with a true scope of disclosed embodiments being indicated by the following claims.

**Claims**

1. A processor-implemented method (300) to generate spatio-temporal intercrop layout, the method comprising:

    receiving (302) via one or more hardware processors a user request comprising a geotagged boundary of an agriculture field and one or more user preferences of expected potential yield, greenhouse gases (GHG) emissions, one or more sustainability scores and combination thereof;
    preprocessing (304) via the one or more hardware processors the user request by removing noise and performing normalization;
    utilizing (306) a pretrained 3D-CNN-LSTM model via the one or more hardware processors to generate an spatio-temporal intercrop layout for each intercropping scenario for the preprocessed user request, by:

        obtaining (306a) the one or more user preferences of expected potential yield, the GHG emissions, one or more sustainability scores and combination thereof;
        generating (306b) the spatio-temporal intercrop layout by recommending one or more intercrop combinations matching user preferences;

    dynamically providing (308) via the one or more hardware processors a visual insight for the spatio-temporal intercrop layout comprising crop growth and corresponding intercrop interaction; and
    obtaining (310) via the one or more hardware processors feedback from at least one of the user as response to the user request or non-invasively in response to the user request for iterative improvements and fine-tuning the 3D-CNN-LSTM model using reinforcement learning.

2. The processor implemented method (300) as claimed in claim 1, wherein the spatio-temporal intercrop layout provides crop growth cycle at varying timelines feasible to intercrop combination of the agricultural field, and corresponding interactions based on agro-climatic, geographic, and farming practices.

3. The processor implemented method (300) as claimed in claim 1, wherein the 3D- CNN-LSTM model is trained by performing the steps of:

    generating a training dataset with data collected from one or more agriculture fields for a predefined time from at least one of drone satellite imagery data and high-resolution satellite imagery data, wherein the training dataset comprises satellite images, farm operations, weather, soil, water, and crop information;
    preprocessing the training dataset by removing noise using a noise removal technique;
    extracting one or more spatio-temporal features from the preprocessed training dataset capturing (i) a spatial distribution and interactions of crops across time for identifying patterns and relationships in spatial domain, and (ii) an temporal dimension to track changes and trends;
    concatenating the one or more spatio-temporal features using the 3D-CNN-LSTM model to determine a comprehensive feature map representing spatio-temporal interactions,

> wherein the 3D-CNN processes the one or more spatial features to identify relationships and patterns between different crops and their environmental characteristics,
> wherein the LSTM processes sequential temporal data to derive one or more temporal features to capture time dependent dynamics of crop growth and interaction;

determining a crop interaction score for the one or more concatenated spatio-temporal features based on a degree of influence where one crop exerts on another considering spatial proximity and temporal growth patterns;
refining the spatio-temporal features using dimensionality reduction and flattening for temporal sequence modeling; and
learning by the 3D-CNN-LSTM model using the refined spatio-temporal features by,

> modifying an interaction-weighted loss function between crops and their corresponding agriculture field, wherein the interaction-weighted loss function is determined using the spatial interaction score and the temporal interaction score for specific interactions, and
> adjusting final output layer predictions by re-weighting the crop interaction score to improve accuracy.

4. The processor implemented method (300) as claimed in claim 3, wherein the crop interaction score includes combination of the spatial interaction score derived from a spatial feature map using the output obtained from 3D-CNNs and the temporal interaction score derived from a temporal feature map based on synchronization timing of crop growth stages using the output obtained from the LSTM.

5. The processor implemented method (300) as claimed in claim 1, wherein the user request is received in time-series which includes high-resolution satellite imagery data, drone imagery data, soil properties, sowing dates, GHG emissions, sustainability scores, and weather data, wherein the one or more user preferences includes user goals, crop yields estimate, GHG emission, and sustainability scores for varying intercropping scenarios.

6. A system (100) to generate spatio-temporal intercrop layout comprising:

> a memory (102) storing instructions;
> one or more communication interfaces (106); and
> one or more hardware processors (104) coupled to the memory (102) via the one or more communication interfaces (106), wherein the one or more hardware processors (104) are configured by the instructions to:

> > receive a user request comprising a geotagged boundary of agriculture field and one or more user preferences of expected potential yield, GHG emissions, one or more sustainability scores and combination thereof;
> > preprocess the user request by removing noise and performing normalization;
> > utilize a pretrained 3D-CNN-LSTM model to generate an optimal spatio-temporal intercrop layout for each intercropping scenario for the preprocessed user request by:

> > > obtaining one or more user preferences of expected potential yield, GHG emissions, one or more sustainability scores and combination thereof;
> > > generating the spatio-temporal intercrop layout by recommending one or more intercrop combinations matching user preferences;

> > dynamically providing an visual insight for the spatio-temporal intercrop layout comprising crop growth and corresponding intercrop interaction; and
> > obtain an user feedback from at least one of the user or non-invasively in response to the user request for iterative improvements and fine-tuning the 3D-CNN-LSTM model using reinforcement learning.

7. The system (100) as claimed in claim 6, wherein the spatio-temporal intercrop layout provides crop growth cycle at varying timelines feasible to intercrop combination of the agricultural field, and corresponding interactions based on agro-climatic, geographic, and farming practices.

8. The system (100) as claimed in claim 6, wherein the 3D-CNN-LSTM model is trained by performing the steps of:

generating a training dataset with data collected from one or more agriculture fields for a predefined time from at least one of drone imagery data and high-resolution satellite imagery data, wherein the training dataset comprises satellite images, farm operations, weather, soil, water, and crop information;
preprocessing the training dataset by removing noise using a noise removal technique;

extracting one or more spatio-temporal features from the preprocessed training dataset capturing (i) a spatial distribution and interactions of crops across time for identifying patterns and relationships in spatial domain, and (ii) an temporal dimension to track changes and trends;
concatenating the one or more spatio-temporal features using the 3D-CNN-LSTM model to determine a comprehensive feature map representing spatio-temporal interactions,

wherein the 3D-CNN processes the one or more spatial features to identify relationships and patterns between different crops and their environmental characteristics,
wherein the LSTM processes sequential temporal data to derive one or more temporal features to capture time dependent dynamics of crop growth and interaction;

determining a crop interaction score for the one or more concatenated spatio-temporal features based on a degree of influence where one crop exerts on another considering spatial proximity and temporal growth patterns;
refining the spatio-temporal features using dimensionality reduction and flattening for temporal sequence modeling; and
learning by the 3D-CNN-LSTM model using the refined spatio-temporal features by,

modifying an interaction-weighted loss function between crops and their corresponding agriculture field, wherein the interaction-weighted loss function is determined using the spatial interaction score and the temporal interaction score for specific interactions, and
adjusting final output layer predictions by re-weighting the crop interaction score to improve accuracy.

9. The system (100) as claimed in claim 8, wherein the crop interaction score includes combination of the spatial interaction score derived from a spatial feature map using the output obtained from 3D-CNNs and the temporal interaction score derived from a temporal feature map based on synchronization timing of crop growth stages using the output obtained from the LSTM.

10. The system (100) as claimed in claim 6, wherein the user request is received in time-series which includes high-resolution satellite imagery data, drone imagery data, soil properties, sowing dates, GHG emissions, sustainability scores, and weather data, wherein the one or more user preferences includes user goals, crop yields estimate, GHG emission, and sustainability scores for varying intercropping scenarios.

11. One or more non-transitory machine-readable information storage mediums comprising one or more instructions which when executed by one or more hardware processors cause:

receiving a user request comprising a geotagged boundary of an agriculture field and one or more user preferences of expected potential yield, greenhouse gases (GHG) emissions, one or more sustainability scores and combination thereof;
preprocessing the user request by removing noise and performing normalization;
utilizing a pretrained 3D-CNN-LSTM model to generate an spatio-temporal intercrop layout for each intercropping scenario for the preprocessed user request, by:

obtaining the one or more user preferences of expected potential yield, the GHG emissions, one or more sustainability scores and combination thereof;
generating the spatio-temporal intercrop layout by recommending one or more intercrop combinations matching user preferences;

dynamically providing a visual insight for the spatio-temporal intercrop layout comprising crop growth and corresponding intercrop interaction; and
obtaining feedback from at least one of the user as response to the user request or non-invasively in response to the user request for iterative improvements and fine-tuning the 3D-CNN-LSTM model using reinforcement learning.

12. The one or more non-transitory machine readable information storage mediums as claimed in claim 11, wherein the spatio-temporal intercrop layout provides crop growth cycle at varying timelines feasible to intercrop combination of the agricultural field, and corresponding interactions based on agro-climatic, geographic, and farming practices.

13. The one or more non-transitory machine readable information storage mediums as claimed in claim 11, wherein the 3D- CNN-LSTM model is trained by performing the steps of:

generating a training dataset with data collected from one or more agriculture fields for a predefined time from at least one of drone satellite imagery data and high-resolution satellite imagery data, wherein the training dataset comprises satellite images, farm operations, weather, soil, water, and crop information;
preprocessing the training dataset by removing noise using a noise removal technique;
extracting one or more spatio-temporal features from the preprocessed training dataset capturing (i) a spatial distribution and interactions of crops across time for identifying patterns and relationships in spatial domain, and (ii) an temporal dimension to track changes and trends;
concatenating the one or more spatio-temporal features using the 3D-CNN-LSTM model to determine a comprehensive feature map representing spatio-temporal interactions,

wherein the 3D-CNN processes the one or more spatial features to identify relationships and patterns between different crops and their environmental characteristics,
wherein the LSTM processes sequential temporal data to derive one or more temporal features to capture time dependent dynamics of crop growth and interaction;

determining a crop interaction score for the one or more concatenated spatio-temporal features based on a degree of influence where one crop exerts on another considering spatial proximity and temporal growth patterns;
refining the spatio-temporal features using dimensionality reduction and flattening for temporal sequence modeling; and
learning by the 3D-CNN-LSTM model using the refined spatio-temporal features by,

modifying an interaction-weighted loss function between crops and their corresponding agriculture field, wherein the interaction-weighted loss function is determined using the spatial interaction score and the temporal interaction score for specific interactions, and
adjusting final output layer predictions by re-weighting the crop interaction score to improve accuracy.

14. The one or more non-transitory machine readable information storage mediums as claimed in claim 13, wherein the crop interaction score includes combination of the spatial interaction score derived from a spatial feature map using the output obtained from 3D-CNNs and the temporal interaction score derived from a temporal feature map based on synchronization timing of crop growth stages using the output obtained from the LSTM.

15. The one or more non-transitory machine readable information storage mediums as claimed in claim 11, wherein the user request is received in time-series which includes high-resolution satellite imagery data, drone imagery data, soil properties, sowing dates, GHG emissions, sustainability scores, and weather data, wherein the one or more user preferences includes user goals, crop yields estimate, GHG emission, and sustainability scores for varying inter-cropping scenarios.

100

Data acquisition

Data storage
/cloud

System

102

**FIG. 1**

System **102**

Hardware Processor(s) 204

I/O Interface(s) 206

Memory 202

Modules 208

Spatio temporal crop interaction
module 210

FIG. 2A

210

Data acquisition module 210a

Preprocessing module 210b

3D-CNN-LSTM 210c

Intercropping interaction scenario simulation module 210d

Prediction & optimization module 210e

Recommendation module 210f

Different crop growth cycles and points of interactions

Crop growth cycles and points of interest for resource demands

Risk stages during a crop growth cycle

FIG. 2B

*300*

receive a user request comprising a geotagged boundary of agriculture field and one or more user preferences of expected potential yield, GHG emissions, one or more sustainability score and combination thereof — *302*

preprocess the user request by removing noise and performing normalization — *304*

utilize a pretrained 3D-CNN-LSTM model to generate an optimal spatio-temporal intercrop layout for each intercrop scenario for the preprocessed user request — *306*

dynamically providing a visual insight for the spatio-temporal intercrop layout comprising crop growth and corresponding intercrop interaction — *308*

obtain a user feedback from at least one of the user or non-invasively in response to the user request for iterative improvements and fine-tuning the 3D-CNN-LSTM model using reinforcement learning — *310*

**FIG. 3**

**210d**

Identifying compatible intercrops

spatial and temporal layouts

**Spatial planning:**

**Potential Layout option 1**
**for crops c1, c2**

**Potential Layout option 2**
**for crops c1, c2**

**Temporal planning**

Option 1: Crop Growth Cycles – c1, c2, c1 & C2

Option 1: Crop Growth Cycles – c1, c2, c1 & C2

c1

c2

c1&

c1

c2

c1&

**FIG. 4A**

T1

T2

T3

c1& c2

T3
T2
T1

Crop 2
(c2)

Crop 1
(c1)

Different crop growth cycles
and points of interactions

**FIG. 4B**

Multi-modal data acquisition about the Crops Growth Cycle and Interaction over long duration (Tn)

FIG.4C

210e

| C1&C2 Crop Interaction Score | C1&C2 Crop Interaction Score | C1&C2 Crop Interaction Score |
|---|---|---|
| Crop Growth Cycle | Crop Growth Cycle | Crop Growth Cycle |

FIG. 5

## EUROPEAN SEARCH REPORT

**Application Number**

EP 25 20 3478

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | JUVENTIA STELLA D ET AL: "Spatio-temporal design of strip cropping systems", AGRICULTURAL SYSTEMS, ELSEVIER, AMSTERDAM, NL, vol. 201, 29 June 2022 (2022-06-29), XP087147475, ISSN: 0308-521X, DOI: 10.1016/J.AGSY.2022.103455 [retrieved on 2022-06-29] * the whole document * | 1-15 | INV. G06V10/82 G06V20/10 G06V20/13 |
| A | CHEN WENLONG ET AL: "Crop Planting Layout Generative Adversarial Network Model", 2023 20TH ANNUAL IEEE INTERNATIONAL CONFERENCE ON SENSING, COMMUNICATION, AND NETWORKING (SECON), IEEE, 11 September 2023 (2023-09-11), pages 27-32, XP034453970, DOI: 10.1109/SECON58729.2023.10287463 [retrieved on 2023-10-23] * the whole document * | 1-15 | |
| A | .Srikanth M. ET AL: "Increasing the Reliability of Intercropping in Agriculture Using Machine Learning", , 15 June 2024 (2024-06-15), pages 1-17, XP093326099, DOI: 10.1201/9781003529231-24 Retrieved from the Internet: URL:researchgate.net/publication/381398303 _Increasing_the_Reliability_of_Intercroppi ng_in_Agriculture_Using_Machine_Learning [retrieved on 2026-01-15] * the whole document * | 1-15 | TECHNICAL FIELDS SEARCHED (IPC) G06V G06N A01B G06Q |

-/--

The present search report has been drawn up for all claims

| Place of search | Date of completion of the search | Examiner |
|---|---|---|
| The Hague | 19 January 2026 | Martinez, Francis |

EPO FORM 1503 03.82 (P04C01)

page 1 of 2

Europäisches
Patentamt

European
Patent Office

Office européen
des brevets

## EUROPEAN SEARCH REPORT

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | CN 106 358 731 A (SHENZHEN ALLWINS TECHNOLOGY CORP) 1 February 2017 (2017-02-01) * abstract * ----- | 1-15 | |

TECHNICAL FIELDS
SEARCHED (IPC)

The present search report has been drawn up for all claims

| Place of search | Date of completion of the search | Examiner |
|---|---|---|
| The Hague | 19 January 2026 | Martinez, Francis |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 20 3478

This annex lists the patent family members relating to the patent documents cited in the above-mentioned European search report.
The members are as contained in the European Patent Office EDP file on
The European Patent Office is in no way liable for these particulars which are merely given for the purpose of information.

19-01-2026

| Patent document cited in search report | Publication date | Patent family member(s) | Publication date |
|---|---|---|---|
| CN 106358731 A | 01-02-2017 | NONE | |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- IN 202421079088